(19) Europäisches Patentamt
European Patent Office
Office européen des brevets

(11) EP 1 310 500 A1

(12) **EUROPEAN PATENT APPLICATION**

(43) Date of publication:
**14.05.2003 Bulletin 2003/20**

(51) Int Cl.[7]: **C07F 7/00**, C07F 19/00, C23C 14/58, C23C 14/24

(21) Application number: **01309542.7**

(22) Date of filing: **12.11.2001**

(84) Designated Contracting States:
**AT BE CH CY DE DK ES FI FR GB GR IE IT LI LU MC NL PT SE TR**
Designated Extension States:
**AL LT LV MK RO SI**

(71) Applicant: **Shipley Co. L.L.C.**
**Marlborough, MA 01752 (US)**

(72) Inventor: **Shin, Hyun-Koock**
**Paldal-gu, Suwon, Kyungki-Do 442-470 (KR)**

(74) Representative: **Kent, Venetia Katherine**
**Rohm and Haas (UK) Ltd**
**European Operations Patent Dept.**
**Lennig House**
**2 Mason's Avenue**
**Croydon, CR9 3NB (GB)**

(54) **Precursor compounds for metal oxide film deposition and methods of film deposition using the same**

(57) Disclosed are precursor compounds useful for deposition of a metal oxide film, which is applied to a capacitor of electronic elements such as semiconductor, to a substrate such as silicon, and process for depositing such film. The precursor compounds have the formula (1):

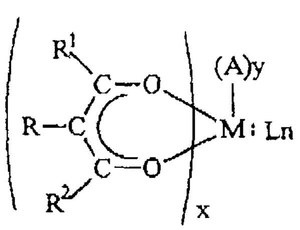

(1)

EP 1 310 500 A1

## Description

Background of Invention

The present invention relates to a compound for metal oxide film deposition and a method for chemical vapor deposition of the film using the same. Specifically, the present invention relates to a preparation of a precursor compound useful for deposition of a material having a high dielectric constant suitable for application to a capacitor of a high integrated semiconductor element, and a method for deposition of a high dielectric metal oxide film on the electrode layer formed on a substrate such as silicon using the present precursor compounds.

Following the tendency toward increasing integration and miniaturization of semiconductor elements, the area of the memory element cell, e.g. DRAM (Dynamic Random Access Memory), becomes rapidly reduced, and therefore, the security of sufficient capacitance in such small area has come to the fore as an important factor of DRAM capacitors.

Since capacitance is proportional to the dielectric constant of the dielectric substance used in the capacitor and an increase in the area of dielectric film and is inversely proportional to an increase in the thickness of film, it may be attempted to obtain a sufficient capacitance in the limited cell area of the miniaturized DRAM by three ways: to reduce the thickness of the film; to increase the available area of the dielectric substance by changing the structure of capacitor; or to improve the dielectric constant using a high dielectric substance.

First, the construction of the capacitor in the form of a three-dimensional steric structure to maximize the available area of the dielectric film in the capacitor within the limited small area should form a very complicated structure. Therefore, the application of a three-dimensional steric structure to the capacitor is limited due to an increase in complexity of the process and a high production cost in DRAM of 256 megs or more, i.e. the I giga age.

Second, the capacitance may be secured by reducing the thickness of the dielectric film. However, when the conventional NO ($Si_3N_4$/SiOx) complex dielectric substance is used, the thickness of the dielectric film should be reduced to 40Å to 45Å so that the minimum capacitance of 25fF to 30fF per cell can be obtained. However, since such reduction of the thickness may cause an increase in leakage current due to a tunneling effect or an increase in soft error due to $\alpha$-particles, the problem of a decrease in confidence of the element is seriously raised.

Third, a high dielectric material may be used as the dielectric substance instead of the currently used low dielectric materials such as ONO of $SiO_2/Si_3N_4$/SiOx or NO of $Si_3N_4$/SiOx.

Under such conditions, it is most preferable to secure the capacitance by using a high dielectric film as the dielectric substance of the capacitor in preparing the high-integrated memory element.

For this purpose, strong dielectric substances such as BST of $(Ba,Sr)TiO_3$ composed of barium oxide (BaO), strontium oxide (SrO) and titanium oxide ($TiO_2$), PLZT of $Pb_{1-x}$-$La_xZr_{1-y}Ti_yO_3$ or PZT of $Pb(Zr,Ti)O_3$, which are the most used high dielectric films at the present time, are preferentially selected as the material of dielectric film for capacitors of next generation DRAMs of 256 megs or more.

Such BST and P(L)ZT films can be prepared by sol-gel methods, sputtering, chemical vapor deposition (CVD), etc. Among these methods for the preparation of films, the CVD method is particularly better than other deposition methods in view of certain properties such as selective deposition or step coverage. Therefore, the CVD method is the most suitable method for preparing films useful in the next generation semiconductor elements requiring a good step coverage in the film deposition following the reduction of cell area.

The formation of BST and PZT films by chemical vapor deposition is accomplished using an organic metal compound called the precursor.

Since compounds such as barium(2,2,6,6-tetramethyl-3,5-heptanedionate)$_2$ as the barium (Ba) compound, strontium(2,2,6,6-tetramethyl-3,5-heptanedionate)$_2$ as the strontium (Sr) compound, lead(2,2,6,6-tetramethyl-3,5-heptanedionate)$_2$ as the lead (Pb) compound, zirconium(2,2,6,6-tetramethyl-3,5-heptanedionate)$_2$ as the zirconium (Zr) compound, or titanium(isopropoxide)$_4$ or titanium(isopropoxide)$_2$(2,2,6,6-tetramethyl-3,5-heptanedionate)$_2$ as the titanium (Ti) compound have the relatively suitable properties for chemical deposition in comparison to the prior other barium, strontium, lead, zirconium, titanium compounds known up to the present, they have been most widely used as the precursor for BST and PZT film deposition.

However, such compounds which currently show relatively good properties as precursors for chemical deposition also have disadvantages, Compounds barium(2,2,6,6-tetramethyl-3,5-heptanedionate)$_2$, strontium(2,2,6,6-tetramethyl-3,5-heptanedionate)$_2$, lead(2,2,6,6-tetramethyl-3,5-heptanedionate)$_2$ and zirconium(2,2,6,6-tetramethyl-3,5-heptanedionate)$_2$ are solids having a low vapor pressure. Therefore, since these precursor compounds should be heated to the high temperature of 200°C or more in order to obtain the vapor pressure required for film deposition, the precursors may be partially decomposed due to such high heating during the film deposition procedure and further, it is difficult to reproductively control the delivery amount of the precursors.

Contrary to this, the compounds titanium(isopropoxide)$_4$ or titanium(isopropoxide)$_2$-(2,2,6,6-tetramethyl-3,5-heptanedionate)$_2$ have the problem that titanium oxide is deposited in an amount greater than the desired composition ratio due to a relatively high vapor pressure in comparison to said other metal compounds.

Such disadvantages cause fatal adverse effects on the reproducability of the process, which is deemed to be the most important factor in preparing a semiconductor.

As one approach to overcome such disadvantages, it has been attempted to use barium, strontium and lead compounds having an organic compound ligand based on alkoxide and carboxylate as the precursor for chemical deposition. However, since these compounds also exhibit the problems of low vapor pressure and thermal instability, they could not provide any improvement in the field of precursors for CVD.

As another attempt, recently the solutions of the prior compounds dissolved in a mixed solvent of tetrahydrofuran and ethyl alcohol has been used as precursors. These precursor solutions could partially solve the thermal instability problem of the compounds and the problem in delivering the precursor in a constant amount, by providing the precursor solution in a controlled constant amount from the precursor reservoir to the vaporizer by means of the direct liquid injector or the liquid delivery system and inducing the instantaneous evaporation, thereby achieving the positive approach to secure the reproductivity of the process.

However, because these prior compounds have a low solubility in tetrahydrofuran, they may be used in the precursor delivery system only in the form of a dilute solution having limited concentration. Therefore, due to such dilute concentration of the precursor solutions the rate of deposition, which generally depends on the concentration of the solution, is not yet sufficient for the preparation of a high dielectric film for capacitors for next generation memory elements. Due to a low solubility, the solvent in the solution re-added to the vaporizer cannot sufficiently dissolve a part of the solid compounds, which is not evaporated and retained in the vaporizer, and therefore, the solid compounds may accumulate and cause occlusion of the vaporizer.

Particularly, in case of the prior titanium compounds the vapor pressure of titanium compound in the solution is relatively high in comparison to other metal compounds. Thus, the titanium compounds have the problem that titanium oxide is present during deposition procedure in an amount greater than the desired composition ratio.

Thus, there is a need to improve the above-mentioned prior precursor solutions for deposition of BST and PZT films, and to provide precursor compounds for metal oxide film deposition, which use the ligand to expand the range for selection of the precursor solutions for various organic metal compounds.

<u>Summary Of Invention</u>

The above-mentioned purpose of the present invention can be attained by providing a precursor compound for metal oxide film deposition, as defined by the following formula (1):

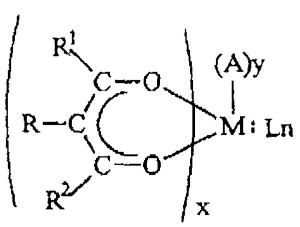

(1)

wherein M is a metal selected from the Groups 2A, 3A, 4A, 5A, 3B, 4B, 5B and 8B of the Periodic Table; x and y are integers of 1 to 4, provided that the sum of x and y is an integer of 2 to 5; R is hydrogen, fluoro, alkyl group containing 1 to 4 carbon atoms, perfluoroalkyl group or perfluoroaryl group; $R^1$ and $R^2$ are independently an alkyl group containing 1 to 8 carbon atoms, perfluoroalkyl group or alkoxyalkyl group; and A is perfluoroalkylalkoxy or alkoxyalkylalkoxy having the formula (2):

$$-O-(CHR^3)_{\ell}-(CR^4R^5)_m-R^6 \qquad (2)$$

wherein $R^3$ is hydrogen, fluoro, or alkyl or perfluoroalkyl containing 1 to 4 carbon atoms, $R^4$ and $R^5$ are the same or different and are hydrogen, fluoro, or alkyl or alkoxy having 1 to 4 carbon atoms, $R^6$ is alkyl or perfluoroalkoxy containing 1 to 4 carbon atoms, or an amide group; $\ell$ and m are integers of 0 to 4; L is a Lewis base; and n is an integer of 0 or more.

The precursor compounds are obtained by reacting a metal salt having a mixed liquid of an alkoxide and a beta-diketonate as a liquid with a Lewis base.

The present invention also provides a solution of the precursor compound described above dissolved in a Lewis base.

The present invention further provides a method for depositing a metal oxide film on a substrate including the step of heating the substrate at a temperature of 300 to 600° C during contact with the precursor compound described above in oxygen.

Brief Description Of Drawings

Figure 1 is a graph showing the result of X-ray diffraction analysis of the film deposited on the silicone substrate by means of chemical deposition according to the present invention.

Detailed Description of the Invention

As the compound of formula (2), an alkoxyalkylalkoxide compound represented by formula (5) is preferably selected, wherein $R^{14}$ is alkyl group having 1 to 5 carbon atoms.

$$-O-(CHR^3)_\ell-(CR^4R^5)m-OR^{14} \quad (5)$$

Among the compounds represented by the formula (5), a 2-alkoxyethoxide of formula (6) is preferred, wherein $R^3$, $R^4$ and $R^5$ are hydrogen and each of $\ell$ and m is 1. As the compound of formula (6), the compound wherein $R^{14}$ is $CH_3$, i.e. 2-methoxyethoxide represented by formula (7), or the compound wherein $R^{14}$ is $C_2H_5$, i.e. 2-ethoxyethoxide represented by formula (8) is preferably selected.

$$-O-(CH_2)_2-OR^{14} \quad (6)$$

$$-O-(CH_2)_2-OCH_3 \quad (7)$$

$$-O-(CH_2)_2-OCH_2CH_3 \quad (8)$$

In formula (1), L is a Lewis base capable of providing an unshared electron pair to the metal center. Preferably, L is a heterocyclic amine having a formula (3) or (4):

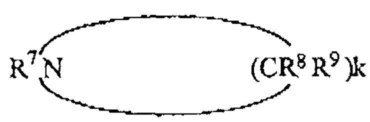

(3)

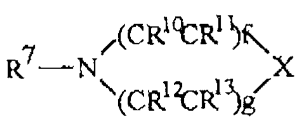

(4)

wherein $R^7$ is hydrogen or alkyl group containing 1 to 4 carbon atoms; $R^8$, $R^9$, $R^{10}$ and $R^{13}$ are the same or different and are hydrogen or alkyl group containing 1 to 2 carbon atoms; and k is an integer of 2 to 8; X is oxygen, or nitrogen having hydrogen or alkyl group containing 1 to 4 carbon atoms; and f and g are integers of 1 to 3.

Suitable Lewis bases include, but are not limited to, aziridine, azetidine, pyrrolidine, piperidine, hexamethyleneimine, heptamethyleneimine, morpholine, piperazine, and the like.

The Lewis base compound of formula (3) is preferably an aziridine represented by the formula (9), a pyrrolidine

represented by the formula (10) or a piperidine represented by the formula (11);

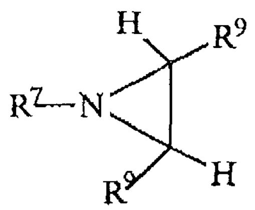

(9)

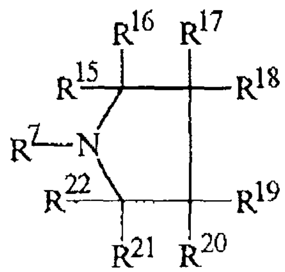

(10)

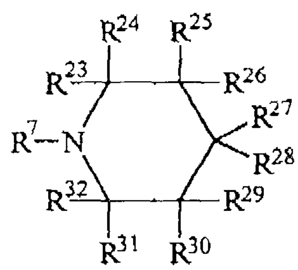

(11)

wherein $R^7$ and $R^9$ are as defined in formula (3) above and $R^{15}$ to $R^{22}$ and $R^{23}$ to $R^{32}$ are the same or different and are hydrogen or alkyl group containing 1 to 2 carbon atoms.

The compound of formula (4) is preferably selected from a morpholine represented by the formula (12) and a piperazine represented by the formula (13):

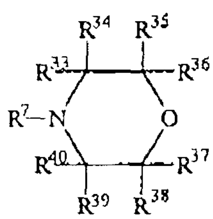

(12)

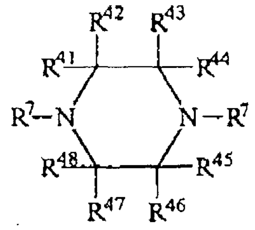

(13)

wherein $R^7$ is as defined in formula (3) and $R^{33}$ to $R^{40}$ and $R^{41}$ to $R^{48}$ are the same or different and are hydrogen or alkyl group containing 1 to 2 carbon atoms.

The compound of formula (10) is preferably a pyrrolidine compound represented by the formula (14). Among the compounds of formula (14), the compound wherein $R^7$ and $R^{15}$ are methyl and $R^{16}$, $R^{18}$, $R^{19}$, $R^{21}$ and $R^{22}$ are hydrogen, i.e. 1,2-dimethylpyrrolidine of formula (15); the compound wherein $R^7$ is $CH_3$ and $R^{15}$ to $R^{22}$ are hydrogen, i.e. 1-methylpyrrolidine of formula (16); and the compound wherein $R^7$ is $C_4H_9$ and $R^{15}$ to $R^{22}$ are hydrogen, i.e. 1-butylpyrrolidine of formula (17) are preferred. The piperidines of formula (11) are preferably a compound wherein $R^7$ is methyl or ethyl and $R^{23}$, $R^{24}$, $R^{26}$, $R^{28}$, $R^{30}$, $R^{31}$ and $R^{32}$ are independently hydrogen or methyl, i.e. an alkylpiperidine of formula (18) from which 1,2,2,6,6-pentamethylpiperidine of formula (19) wherein $R^7$, $R^{23}$, $R^{24}$, $R^{31}$ and $R^{32}$ are methyl and $R^{26}$, $R^{28}$ and $R^{30}$ are hydrogen or 1-methylpiperidine and 1-ethylpiperidine of formulas (20) and (21), respectively, are particularly preferable.

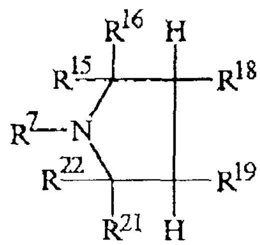

(14)

In the above formula (14), $R^7$ is as defined in formula (3) and $R^{15}$, $R^{16}$, $R^{18}$, $R^{19}$, $R^{21}$ and $R^{22}$ are independently hydrogen or methyl.

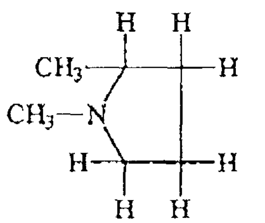

(15)

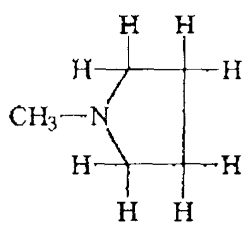

(16)

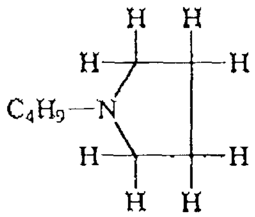

(17)

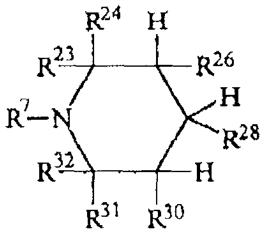

(18)

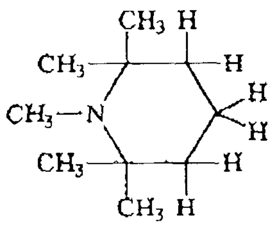

(19)

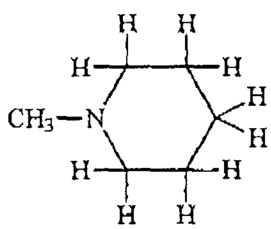

(20)

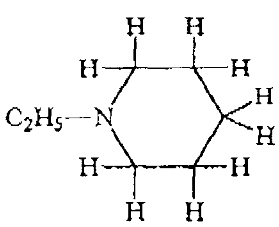

(21)

Among the compounds of formula (4), the morpholine compounds of formula (12), particularly 4-methylmorpholine of formula (22) and 4-ethylmorpholine of formula (23) are preferred. Among the piperazine compounds of formula (13), 1,4-dimethyl-piperazine of formula (24) is preferably used.

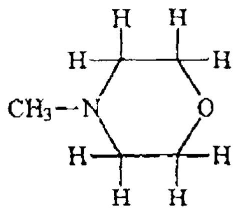

(22)

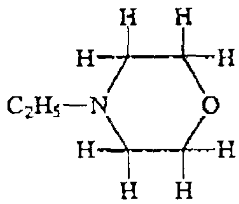

(23)

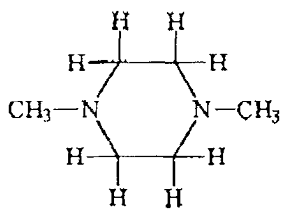

(24)

The precursor compounds of the present invention, as defined by formula (1), can be readily prepared by adding a beta-diketone to a metal alkoxide, preferably by dropwise addition; thoroughly stirring the mixture; adding a perfluoroalkylalcohol or an alkoxyalkylalcohol to the mixture; stirring the mixture for a period of time such as at 50°C for 6 hours; drying the mixture under vacuum; reacting the mixture with a heterocyclic amine; and then distillating the mixture, as shown in the following reaction scheme 1.

- Reaction Scheme 1

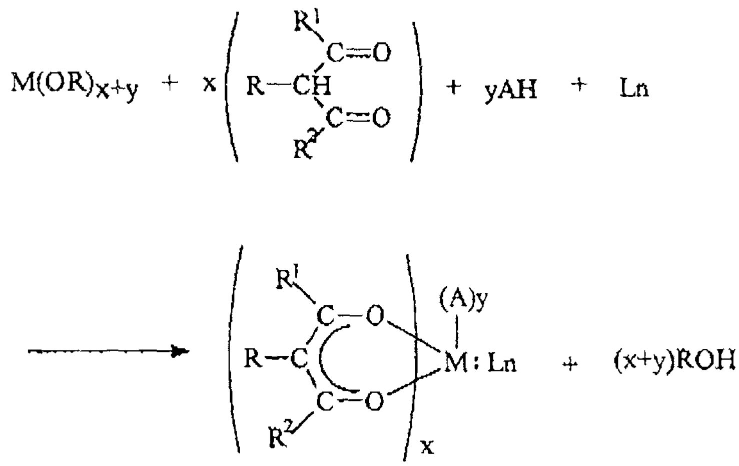

In the above Reaction Scheme 1, M, x, y, R, $R^1$, $R^2$, A, L and n are as defined in formula (1) above.

In addition, the present invention provides a solution of the precursor compound for metal oxide film deposition, which solution is prepared by dissolving the precursor compound of formula (1) in a Lewis base solvent as defined in formulas (3) and (4).

It is preferred to use the pyrrolidine of formula (10), the piperidine of formula (11), the morpholine of formula (12) or the piperazine of formula (13) in preparing solutions of the present precursor compounds.

More preferably, the pyrrolidine of formula (10), wherein $R^7$ is methyl and $R^{15}$ to $R^{22}$ are hydrogen, i.e. 1-methylpyrrolidine of formula (16), can be used. More particularly, the piperidine of formula (11) wherein $R^7$ is methyl and $R^{23}$ to $R^{32}$ are hydrogen, i.e. 1-methylpiperidine of formula (20), and the piperidine of formula (11) wherein $R^7$ is ethyl and $R^{23}$ to $R^{32}$ are hydrogen, i.e. 1-ethylpiperidine of formula (21), can be used. More preferably, the morpholine of formula (12) wherein $R^7$ is ethyl and $R^{33}$ to $R^{40}$ are hydrogen, i.e. 4-ethylmorpholine of formula (23) can be used. More particularly, the piperazine of formula (13) wherein $R^7$ is methyl and $R^{41}$ to $R^{48}$ are hydrogen, i.e. 1,4-dimethylpiperazine of formula (24) is preferred.

Particularly, it is preferred to use the solution of the compound of formula (1) wherein the beta-diketonate is 2,2,6,6-tetramethyl-3,5-heptanedionate (hereinafter, abbreviated to "tetramethylheptanedionate") and the metal M is strontium (Sr) or barium (Ba) of Group 2A, lead (Pb) of Group 4A, bismuth (Bi) of Group 5A, lanthanum (La) of Group 3B, titanium (Ti) or zirconium (Zr) of Group 4B or tantalum (Ta) of Group 5B, dissolved in heterocyclic amine of formula (3) or (4) as the precursor solution in a liquid injection delivery system. More particularly, the compound containing strontium or barium of Group 2A or zirconium or titanium of Group 4B is preferably used as the precursor solution for BST or PZT film.

The precursor solution of the compound of formula (1) dissolved in a Lewis base of formula (3) or (4) does not cause any precipitation or decomposition even when it is stored in the form of a mixture with the solution of other metal compound for a long period, and can be prepared in a high concentration due to the high solubility of the compound (1). In addition, due to the high solubility and the unique property of the Lewis base solvent capable of providing an electron pair to the metal center, it is possible to prepare a mixed solution of numerous compounds such as barium, strontium and titanium compounds. Therefore, the precursor solution according to the present invention is an ideal precursor solution for deposition of a high dielectric film of the high-integrated DRAM capacitor by means of the chemical deposition.

Furthermore, the present invention provides a method for chemical deposition of the high dielectric film on the substrate heated to the deposition temperature ranging from 300 to 600°C while supplying oxygen during a conventional deposition procedure, in order to effectively deposit the metal oxide film from the precursor compound or the precursor solution, as described above

In addition, in carrying out the chemical deposition of said film it is preferred to utilize a heat energy or plasma as the excitation source of process gas or to apply a bias to the substrate.

Thus, the present inventor intends to more specifically explain the present invention with reference to the preparation of the precursor compounds of formula (1). For purposes of illustration only, titanium compounds of formula

(25),

$$[C_{11}H_{19}O_2]_2—Ti[O—(CHR^3)_\ell(CR^4R^5)m—OR^{14}]_2 \quad (25)$$

wherein $R^3$ to $R^5$ and $\ell$ and m are as defined in formula (2) and $R^{14}$ is as defined in formula (5), containing tetramethylheptanedionate and alkoxyalkylalkoxide as the mixed ligand, can be used in both BST and PZT film deposition and have vapor pressures similar to that of other metal compounds. Mixed solutions of such compounds can be prepared by using the Lewis base compounds of formula (3) or (4) as the solvent.

Among the compounds of formula (25), it is preferred to select the compound wherein $R^3$ to $R^5$ are hydrogen and $\ell$ and m are 1, i.e. titanium(alkoxyethoxy)$_2$(2,2,6,6-tetramethyl-3,5-heptanedionate)$_2$ represented by the formula (26).

$$(C_{11}H_{19}O_2)_2—Ti—(OCH_2CH_2OR^{14})_2 \quad (26)$$

In the above formula (26), $R^{14}$ is preferably alkyl group containing 1 to 5 carbon atoms. The compound wherein $R^{14}$ is methyl, i.e. titanium(methoxyethoxy)$_2$-(2,2,6,6-tetramethyl-3,5-heptanedionate)$_2$, represented by the formula (27), and the compound wherein $R^{14}$ is ethyl, i.e. titanium(ethoxyethoxy)$_2$(2,2,6,6-tetramethyl-3,5-heptanedionate)$_2$, represented by the formula (28), are more preferable.

$$(C_{11}H_{19}O_2)_2—Ti—(OCH_2CH_2OCH_3)_2 \quad (27)$$

$$(C_{11}H_{19}O_2)_2—Ti—(OCH_2CH_2OCH_2CH_3)_2 \quad (28)$$

The use of the precursor solution of the present compounds in chemical deposition processes using the liquid precursor delivery system provides the following effects.

First, contrary to titanium compounds conventionally used for BST and PZT film deposition, the titanium compound of formula (25), although having similar evaporation temperature and vapor pressure to other metal compounds such as Ba, Sr, Pb and Zr compounds, it can be prepared in the form of a mixed solution with other metal compounds so that the desired composition ratio can be readily achieved in depositing BST and PZT films by chemical vapor deposition using a liquid precursor delivery system. Further, the use of the titanium compound of formula (25) also prevents the aggregation of titanium compound in the deposited film, which could be caused by a high vapor pressure of the prior art titanium compounds in comparison to other metal compounds.

Second, since the compound of formula (25) has a high solubility in the heterocyclic amine Lewis base ligand used as the solvent, it is possible to use the precursor solution in a high concentration so that an improvement in the rate of film deposition can be expected.

Third, when a mixed solution is prepared using the prior solvent such as tetrahydrofuran, the precursor mixed solution for BST and PZT deposition may often lead to a precipitate due to the reactivity between the solute compounds in the solution and their low solubility. While not wishing to be bound by theory, it is believed that when the heterocyclic amine Lewis base as defined in formulas (3) and (4) is used as the solvent, the solvation of the metal compounds by the Lewis base prohibits chemical reaction between solvates and further, the high solubility is maintained, thereby not forming any precipitate.

In general, two or more precursor solutions should be delivered to the deposition reactor from separate precursor reservoirs via separate delivery tubes. However, since the mixed solution according to the present invention has the above-mentioned properties, it can be delivered from one container via only one delivery tube to the deposition reactor, thereby simplifying the deposition procedure.

Among the compound of formula (1) according to the present invention, the compounds of formula (25) having tetramethylheptanedionate and alkoxyalkylalkoxide, which are used in both the mixed solutions for BST and PZT film deposition, as the mixed ligand and the precursor solution thereof can be prepared through the following process. The whole procedures of the process should be carried out under nitrogen or argon gas stream as the inert gas to prevent the deterioration of the compound due to the contact with air.

Hereinafter, the processes for preparation of the compound and the precursor solution according to the present invention will be more specifically illustrated by the following examples.

Example 1

Synthesis of titanium(2-methoxyethoxy)$_2$(tetramethylheptanedionate)$_2$

Under a nitrogen gas stream, 387 g (2.1 mol) of tetramethylheptanedione was added dropwise to 284 g (1 mol) of titanium(isopropoxide)$_4$ at room temperature and the mixture was stirred for about 3 hours at room temperature. Then, 304 g (4 mol) of 2-methoxyethanol was added to the mixture at room temperature and stirred with refluxing for 6 hours at 50°C to complete the reaction.

After the reaction was completed, in order to remove any volatile side product, the mixture containing titanium (2-methoxyethoxy)$_2$(tetramethylheptanedionate)$_2$ was dried under vacuum at 70°C to obtain 575 g of the deep yellow liquid.

The dried deep yellow liquid was distilled at 140°C while maintaining a vacuum ($10^{-2}$ torr) to condense the pale yellow distillate in a container cooled with dry ice. The first distillate was purified at 140°C according the same procedure as above to obtain 519 g of the pale yellow titanium(2-methoxyethoxy)$_2$(tetramethylheptanedionate)$_2$ having a high purity.

The chemical reaction for preparing titanium(2-methoxyethoxy)$_2$(tetramethylheptane-dionate)$_2$ according to the present invention is represented by the following Reaction Scheme 2 and the analytical data as determined by NMR (nuclear magnetic resonance) spectroscopy and the observed physical data of the high purified titanium(2-methoxy-ethoxy)$_2$(tetramethylheptanedionate)$_2$ are shown in the following Table 1.

Reaction Scheme 2

$$Ti[OCH(CH_3)_2]_4 + 2\,[(CH_3)_3CCOCH_2COC(CH_3)_3] + 2\,[CH_3O(CH_2)_2OH]$$

$$\rightarrow Ti[O(CH_2)_2OCH_3]_2[(CH_3)_3CCOCHCOC(CH_3)_3]_2 + 4HOCH(CH_3)_2$$

Example 2

Synthesis of titanium(1-methoxy-2-propoxy)$_2$(tetramethylheptanedionate)$_2$

According to the procedure of Example 1, 387 g (2,1 mol) of tetramethylheptanedione was added to 284 g (1 mol) of titanium(isopropoxide)$_4$ and then the mixture was stirred for 3 hours at room temperature. Then, 361 g (4 mol) of 1-methoxy-2-propanol was added to the mixture and stirred for 6 hours at 50°C to complete the reaction.

After the reaction was completed, in order to remove any volatile side product the mixture was dried under vacuum at 70°C to obtain 504 g of the solid titanium(1-methoxy-2-propoxy)$_2$(tetramethylheptanedionate)$_2$.

The resulting solid titanium(1-mcthoxy-2-propoxy)$_2$(tetramethylheptanedionate)$_2$ was sublimed at 150°C under vacuum ($10^{-2}$ torr) to purify the product.

The chemical reaction for preparing titanium(1-methoxy-2-propoxy)$_2$(tetramethylheptanedionate)$_2$ according to the present invention is represented by the following reaction scheme 3 and it was confirmed from the analytical data as determined by NMR spectroscopy and the observed physical properties, as shown in the following Table 1, that the resulting product was titanium(1-methoxy-2-propoxy)$_2$(tetramethylheptanedionate)$_2$.

Reaction Scheme 3

$$Ti[OCH(CH_3)_2]_4 + 2\,[(CH_3)_3CCOCH_2COC(CH_3)_3] + 2\,[CH_3OCH_2CH(CH_3)OH]$$

$$\rightarrow Ti[O(CH_3)CHCH_2OCH_3]_2[(CH_3)_3CCOCHCOC(CH_3)_3]_2 + 4\ HOCH(CH_3)_2$$

Example 3

Synthesis of titanium(1-methoxy-2-butoxy)$_2$(tetramethylheptanedionate)$_2$

According to the procedure of Example 1, 387 g (2,1 mol) of tetramethylheptanedione was added dropwise to 284 g (1 mol) of titanium(isopropoxide)$_4$ and then the mixture was stirred. Then, 417 g (4 mol) of 1-methoxy-2-butanol was added to the mixture and the reaction was completed. The reaction mixture was dried under vacuum to obtain 521 g of the solid titanium(1-methoxy-2-butoxy)$_2$(tetramethylheptane-dionate)$_2$.

The dried titanium(1-methoxy-2-butoxy)$_2$(tetramethylheptanedionate)$_2$ was sublimed at 160°C under vacuum to purify the product.

The chemical reaction for preparing titanium(1-methoxy-2-butoxy)$_2$(tetramethylheptanedionate)$_2$ is represented by the following reaction scheme 4 and it was confirmed from the analytical data as determined by NMR spectroscopy and the observed physical properties, as shown in the following Table 1, that the resulting product was titanium (1-methoxy-2-butoxy)$_2$(tetramethyl-heplanedionate)$_2$.

Reaction Scheme 4

$$Ti[OCH(CH_3)_2]_4 + 2\ [(CH_3)_3CCOCH_2COC(CH_3)_3] + 2(CH_3OCH_2CH(CH_2CH_3)OH]$$

$$\rightarrow Ti[OCH(CH_2CH_3)CH_2OCH_3]_2[(CH_3)_3CCOCHCOC(CH_3)_3]_2 + 4\ HOCH(CH_3)_2$$

Example 4

Synthesis of titanium(3-methoxy-1-butoxy)$_2$(tetramethylheptanedionate)$_2$

According to the procedure of Example 1, 387 g (2.1 mol) of tetramethylheptanedione was added dropwise to 284 g (1 mol) of titanium(isopropoxide)$_4$ and then the mixture was stirred. Then, 417 g (4 mol) of 3-methoxy-1-butanol was added to the mixture and the reaction was completed.

After the reaction was completed, the mixture was dried under vacuum at about 70°C and then distilled twice at 145°C under vacuum to obtain 559 g of the pale yellow liquid titanium(3-methoxy-1-butoxy)$_2$(tetramethylheptanedionate)$_2$ having a high purity.

The chemical reaction for preparing titanium(3-methoxy-1-butoxy)$_2$(tetramethylheptanedionate)$_2$ is represented by the following reaction scheme 5 and it was confirmed from the analytical data as determined by NMR spectroscopy and the observed physical properties, as shown in the following Table 1, that the resulting product was titanium (3-methoxy-1-butoxy)$_2$(tetramethyl-heptanedionate)$_2$.

Reaction Scheme 5

$$Ti[OCH(CH_3)_2]_4 + 2\ [(CH_3)_3CCOCH_2COC(CH_3)_3] + 2\ [CH_3OCH(CH_3)CH_2CH_2OH]$$

$$\rightarrow Ti[OCH_2CH_2CH(CH_3)OCH_3]_2[(CH_3)_3CCOCHCOC(CH_3)_3]_2 + 4\ HOCH(CH_3)_2$$

Example 5

Synthesis of titanium(2-ethoxyethoxy)$_2$(tetramethylheptanedionate)$_2$

According to the procedure of Example 1, 387 g (2,1 mol) of tetramethylheptanedione was added dropwise to 284 g (1 mol) of titanium(isopropoxide)$_4$ with stirring and then, 361 g (4 mol) of 2-ethoxyethanol was added to the mixture. When the reaction was completed, the reaction mixture was dried at 70°C under vacuum to obtain 652 g of the deep yellow liquid.

The dried deep yellow liquid was distilled at 160°C under vacuum to condense the first pale yellow distillate in a container cooled with dry ice. The first distillate was purified according the same procedure as above to obtain 551 g of the pale yellow titanium(2-ethoxyethoxy)$_2$(tetramethylheptanedionate)$_2$ having a high purity.

The chemical reaction for preparing titanium(2-ethoxyethoxy)$_2$(tetramethylheptanedionate)$_2$ according to the present invention is represented by the following reaction scheme 6 and the analytical data as determined by NMR spcctroscopy and the observed physical properties of the high purified titanium(2-methoxyethoxy)$_2$(tetramethyl-heptanedionate)$_2$ are shown in the following Table 1.

Reaction Scheme 6

$$Ti[OCH(CH_3)_2]_4 + 2\ [(CH_3)_3CCOCH_2COC(CH_3)_3] + 2\ [CH_3CH_2OCH_2CH_2OH]$$

$$\rightarrow Ti[O(CH_2)_2OCH_2CH_3]_2[(CH_3)_3CCOCHCOC(CH_3)_3]_2 + 4\ HOCH(CH_3)_2$$

Example 6

Synthesis of titanium(3-ethoxy-1-propoxy)$_2$(tetrametlylheptanedionate)$_2$

According to the procedure of Example 1, 387 g (2,1 mol) of tetramethylheptanedione was added dropwise to 284 g (1 mol) of titanium(isopropoxide)$_4$ with stirring and then, 417 g (4 mol) of 3-ethoxy-1-propanol was added to the mixture and stirred.

After the reaction was completed, the mixture was dried at 70°C under vacuum to obtain 640 g of the liquid product. The dried deep yellow liquid was then distilled at 170°C under vacuum to obtain 557 g of the pale yellow titanium(3-ethoxy-1-propoxy)$_2$-(tetramethylheptanedionate)$_2$ having a high purity.

The chemical reaction for preparing titanium(3-ethoxy-1-propoxy)$_2$(tetramethylheptanedionate)$_2$ according to the present invention is represented by the following reaction scheme 7 and the high purified titanium(3-ethoxy-1-propoxy)$_2$(tetramethyl-heptanedionate)$_2$ has the analytical data as determined by NMR spectroscopy and the observed physical properties as shown in the following Table 1.

Reaction Scheme 7

$$Ti[OCH(CH_3)_2]_4 + 2\ [(CH_3)_3CCOCH_2COC(CH_3)_3] + 2\ [CH_3CH_2O(CH_2)_3OH]$$

$$\rightarrow Ti[O(CH_2)_3OCH_2CH_3]_2[(CH_3)_3CCOCHCOC(CH_3)_3]_2 + 4\ HOCH(CH_3)_2$$

Example 7

Synthesis of titanium(3,3-diethoxy-1-propoxy)$_2$(tetramethylheptanedionate)$_2$

According to the procedure of Example 1, 387 g (2.1 mol) of tetramethylheptanedione was added dropwise to 284 g (1 mol) of titanium(isopropoxide)$_4$ with stirring and then, 593 g (4 mol) of 3,3-diethoxy-1-propanol was added. When the reaction was completed, the reaction mixture was dried at 70°C under vacuum and then distilled twice at 150°C under vacuum to obtain 631 g of the pale yellow liquid titanium(3,3-diethoxy-1-propoxy)$_2$(tetramethylheptanedionate)$_2$ having a high purity.

The chemical reaction for preparing titanium(3,3-diethoxy-1-propoxy)$_2$(tetramethylheptanedionate)$_2$ is represented by the following reaction scheme 8 and it was confirmed from the analytical data as determined by NMR spectroscopy and the observed physical properties, as shown in the following Table 1, that the resulting product was titanium (3,3-diethoxy-1-propoxy)$_2$(tetramethyl-heptanedionate)$_2$

Reaction Scheme 8

$$Ti[OCH(CH_3)_2]_4 + 2\ [(CH_3)_3CCOCH_2COC(CH_3)_3] + 2\ [(CH_3CH_2O)_2CH(CH_2)_2OH]$$

$$\rightarrow Ti[O(CH_2)_2CH(OCH_2CH_3)_2]_2[(CH_3)_3CCOCHCOC(CH_3)_3]_2 + 4\ HOCH(CH_3)_2$$

Example 8

Synthesis of titanium(2-propoxyethoxy)$_2$(tetramethylheptanedionate)$_2$

According to the procedure of Example 1, 387 g (2,1 mol) of tetramethylheptanedione was added dropwise to 284 g (1 mol) of titanium(isopropoxide)$_4$ with stirring and then, 417 g (4 mol) of 2-propoxyethanol was added to the mixture at room temperature and stirred.

After the reaction is completed, the mixture was dried under vacuum at 70°C to obtain 658 g of the liquid. The dried deep yellow liquid was distilled at 155°C under vacuum to obtain 590 g of the pale yellow titanium(2-propoxyethoxy)$_2$(tetramethylheptane-dionate)$_2$ having a high purity.

The chemical reaction for preparing titanium(2-propoxyethoxy)$_2$(tetramethylheptanedionate)$_2$ according to the present invention is represented by the following reaction scheme 9 and the high purified titanium(2-propox-

yethoxy)$_2$(tetramethyl-heptanedionate)$_2$ has the analytical data as determined by NMR spectroscopy and the observed physical properties as shown in the following Table 1.

Reaction Scheme 9

$$Ti[OCH(CH_3)_2]_4 + 2\ [(CH_3)_3CCOCH_2COC(CH_3)_3] + 2\ [CH_3(CH_2)_2O(CH_2)_2OH]$$

$$\rightarrow Ti[O(CH_2)_2O(CH_2)_2CH_3]_2[(CH_3)_3CCOCHCOC(CH_3)_3]_2 + 4\ HOCH(CH_3)_2$$

Example 9

Synthesis of titanium(2-butoxyethoxy)$_2$(tetramethylheptanedionate)$_2$

According to the procedure of Example 1 387 g (2.1 mol) of tetramethylheptanedione was added dropwise to 284 g (1 mol) of titanium(isopropoxide)$_4$ and then stirred. Then, 473 g (4 mol) of 2-butoxyethanol was added to the mixture. When the reaction was completed, the reaction mixture was dried at 70°C under vacuum to obtain the deep yellow liquid, which was then distilled at 165°C under vacuum to obtain 603 g of the pale yellow titanium(2-butoxyethoxy)$_2$(tetramethylheptanedionate)$_2$ having a high purity.

The chemical reaction for preparing titanium(2-butoxyethoxy)$_2$(tetramethylheptanedionate)$_2$ according to the present invention is represented by the following reaction scheme 10 and the analytical data as determined by NMR spectroscopy and the observed physical data of the high purified titanium(2-butoxyethoxy)$_2$(tetramethylheptane-dionate)$_2$ are shown in the following Table 1.

Reaction Scheme 10

$$Ti[OCH(CH_3)_2]_4 + 2\ [(CH_3)_3CCOCH_2COC(CH_3)_3] + 2\ [CH_3(CH_2)_3O(CH_2)_2OH]$$

$$\rightarrow Ti[O(CH_2)_2O(CH_2)_3CH_3]_2[(CH_3)_3CCOCHCOC(CH_3)_3]_2 + 4\ HOCH(CH_3)_2$$

Example 10

Synthesis of titanium(2-isopropoxyethoxy)$_2$(tetramethylheptanedionate)$_2$

According to the procedure of Example 1, 387 g (2.1 mol) of tetramethylheptanedione was added dropwise to 284 g (1 mol) of titanium(isopropoxide)$_4$ and then stirred. Then, 417 g (4 mol) of 2-isopropoxyethanol was added to the mixture. When the reaction was completed, the reaction mixture was dried at 70°C under vacuum to obtain the yellow liquid, which was then distilled at 170°C under vacuum to obtain 596 g of the pale yellow titanium(2-isopropoxyethoxy)$_2$(tetramethylheptanedionate)$_2$ having a high purity.

The chemical reaction for preparing titanium(2-isopropoxyethoxy)$_2$(tetramethylheptanedionate)$_2$ according to the present invention is represented by the following reaction scheme 11 and the analytical data as determined by NMR spectroscopy and the observed physical data of the high purified titanium(2-isopropoxycthoxy)$_2$(tetramethylheptanedionate)$_2$ are shown in the following Table 1.

Reaction Scheme 11

$$Ti[OCH(CH_3)_2]_4 + 2\ [(CH_3)_3CCOCH_2COC(CH_3)_3] + 2\ [(CH_3)_2CHO(CH_2)_2OH]$$

$$\rightarrow Ti[O(CH_2)_2OCH(CH_3)_2]_2[(CH_3)_3CCOCHCOC(CH_3)_3]_2 + 4\ HOCH(CH_3)_2$$

Table 1

| Example | Compounds | Form | Color | H-NMR (solvent $C_6D_6$, ppm) |
|---|---|---|---|---|
| Example 1 | titanium (2-methoxyethoxy)$_2$-(tetramethylheptanedionate)$_2$ | liquid | pale yellow | 1.03(s, 18H), 1.20 (s, 18H), 3.20(s, 6H), 3.50(t, 4H), 4.75(m, 4H), 5.85 (s, 2H) |
| Example 2 | titanium(1-methoxy-2-propoxy)$_2$-(tetramethylheptanedionate)$_2$ | solid | white | 1.03(s, 18H), 1.20 (s, 18H), 1.30(d, 6H), 3.00(s, 2H), 3.30(s, 6H), 5,85(s, 2H) |
| Example 3 | titanium(1-methoxy-2-butoxy)$_2$-(tetramethylheptanedionate)$_2$ | solid | white | 1.03(s, 18H), 1.20 (s, 18H), 1.30(s, 6H), 3.00(s, 2H), 3.20(br s, 6H), 3.50 (t, 4H), 5.58(s, 2H) |
| Example 4 | titanium(3-methoxy-1-butoxy)$_2$-(tetramethylhepatanedionate)$_2$ | liquid | pale yellow | 1.03(s, 18H), 1.11 (d, 6H), 1.20(s, 18H), 1.95(m, 4H), 3.20(br s, 6H), 3.55 (m, 2H), 4.72 (m, 4H), 5.85(s, 2H) |
| Example 5 | titanium (2-ethoxyethoxy)$_2$-(tetramethylheptanedionate)$_2$ | liquid | pale yellow | 1.03(s, 18H), 1.20 (s, 18H), 1.30(m, 6H), 3.40(q, 4H), 3.60(t, 4H), 4.80(br s, 4H), 5.85(s, 2H) |
| Example 6 | titanium(3-ethoxy-1-propoxy)$_2$-(tetramethylheptanedionate)$_2$ | liquid | pale yellow | 1.03(s, 18H), 1.20 (s, 18H), 1.30(m, 6H), 1.95(t, 4H), 3.40(q, 4H), 4.72 (m, 4H), 4.75(m, 4H), 5.85(s, 2H) |
| Example 7 | titanium(3,3-diethoxy-1-propoxy)$_2$-(tetramethylheptanedionate)$_2$ | liquid | pale yellow | 1.03(s, 18H), 1.20 (s, 18H), 1.30(t, 12H), 3.40(q, 8H), 3.60(m, 4H), 3.75 (m, 4H), 4.70(t, 2H), 5.85(s, 2H) |
| Example 8 | titanium (2-propoxyethoxy)$_2$-(tetramethylheptanedionate)$_2$ | liquid | pale yellow | 0.85(t, 6H), 1.03(s, 18H), 1.20(s, 18H), 1.50(m, 4H), 3.35(t, 4H), 3.60(t, 4H), 4.75(br s, 4H), 5.85 (s, 2H) |

Table 1 (continued)

| Example | Compounds | Form | Color | H-NMR (solvent $C_6D_6$, ppm) |
|---|---|---|---|---|
| Example 9 | titanium (2-butoxyethoxy)$_2$-(tetramethylhepatanedionate)$_2$ | liquid | pale yellow | 0.85(t, 6H), 1.03(s, 18H), 1.20(s, 18H), 1.32(m, 4H), 1.52 (m, 4H), 3.40(t, 4H), 3.63(t, 4H), 4.82(br s, 4H), 5.85(s, 2H) |
| Example 10 | titanium (2-isopropoxyethoxy)$_2$-(tetramethylheptanedionate)$_2$ | liquid | pale yellow | 1.03(s, 18H), 1.11 (d, 6H), 1.13(d, 6H), 3.60(t, 4H), 3.80(m, 2H), 4.80(br s, 4H), 5.85(s, 2H) |

Example 11

Preparation of the mixed precursor solution of barium tetramethylheptanedionate, strontium tetramethylheptanedionate and titanium(2-methoxyethoxy)$_2$(tetra-methylheptanedionate)$_2$

5,74 g of barium tetramethylheptanedionate, 3.0 g of strontium tetramethylheptanedionate and 14,4 g of titanium(2-methoxyethoxy)$_2$(tetramethylheptanedionate)$_2$ were mixed. The resulting mixture was dissolved in 300 ml of purified, colorless 1-ethylpiperidine to prepare the pale yellow mixed solution containing barium tetramethylheptanedionate, strontium tetramethylheptanedionate and titanium(2-methoxyethoxy)$_2$(tetramethylheptanedionate)$_2$. This mixed solution did not form any precipitate nor discolor, even after storage for 6 months,

Example 12

Eight ml of the pale yellow mixed solution prepared from Example 11 was vaporised using a vacuum pressure of $1\times10^{-2}$ torr with heating at 200°C and then chemically deposited on a 900Å titanium nitride (TiN) substrate deposited on a silicon substrate which was heated to 350°C to 550°C.

The deposited BST film was analyzed by means of XRD (X-ray diffraction) which showed that the film was composed of barium, strontium, titanium and oxygen constituents.

As can be seen from the above examples, the precursor compound and the mixed solution according to the present invention have good effects of not causing any decomposition nor precipitation even after long term storage, possibly preparing the precursor solution in a high concentration due to a good solubility, and not causing the clogging of the vaporizer such as liquid injector or liquid delivery system.

## Claims

**1.** A precursor compound for metal oxide film deposition, of the formula (1),

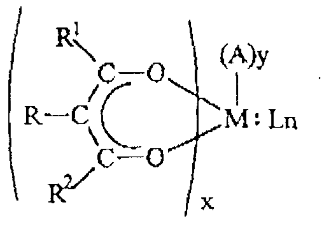

(1)

wherein

M is a metal element selected from the group consisting of Groups 2A, 3A, 4A, 5A, 3B, 4B, 5B and 8B of the Periodic Table;
- x and y are integers of 1 to 4, provided that the sum of x and y is an integer of 2 to 5;
R is hydrogen, fluoro, alkyl group containing 1 to 4 carbon atoms, perfluoroalkyl group or perfluoroaryl group;
$R^1$ and $R^2$ are independently an alkyl group containing 1 to 8 carbon atoms, perfluoroalkyl group or alkoxyalkyl group;
A is perfluoroalkylalkoxy or alkoxyalkylalkoxy having the formula (2),

$$—O—(CHR^3)_\ell—(CR^4R^5)m—R^6 \quad (2)$$

wherein
$R^3$ is hydrogen, fluoro, or alkyl or perfluoroalkyl having 1 to 4 carbon atoms;
$R^4$ and $R^5$ are the same or different and are hydrogen, fluoro or alkyl or alkoxy having 1 to 4 carbon atoms;
$R^6$ is an alkyl or perfluoroalkoxy having 1 to 4 carbon atoms, or an amide group;
and $\ell$ and m are integers of 0 to 4;
L is a Lewis base capable of providing an unshared electron pair to the metal; and n is an integer of 0 or more.

**2.** The precursor compounds of claim 1, wherein M is selected from the group consisting of calcium, strontium, barium, lead, bismuth, lanthanum, titanium, zirconium and tantalum.

**3.** The precursor compound of claim 1, wherein M is selected from the group consisting of zirconium and titanium; the sum of x and y is 4; and n is 0.

**4.** The precursor compound of claim 3, wherein M is titanium; x is 2; and y is 2.

**5.** The precursor compound of claim 4, having the, formula (25):

$$[C_{11}H_{19}O_2]_2—TiO\{CHR_3)_\ell(CR^4R^5)m—OR^{14}]_2 \quad (25)$$

wherein $R^3$ is hydrogen fluoro, or alkyl or perfluoroalkyl having 1 to 4 carbon atoms;
$R^4$ and $R^5$ are the same or different and are hydroalgen, fluoro or alkyl or alkoxy having 1 to 4 carbon atoms;
$\ell$ and m are integers of 0 to 4;
and $R^{14}$ is an alkyl group containing 1 to 5 carbon atoms.

**6.** The precursor compound of claim 1, wherein A has the formula (5):

$$—O—(CHR^3)_\ell—(CR^4R^5)m—OR^{14} \quad (5)$$

wherein $R^3$ is hydrogen fluoro, or alkyl or perfluoroalkyl having 1 to 4 carbon atoms;
$R^4$ and $R^5$ are the same or different and are hydrogen, fluoro or alkyl or alkoxy having 1 to 4 carbon atoms;
$\ell$ and m are integers of 0 to 4;
and $R^{14}$ is an alkyl group containing 1 to 5 carbon atoms.

**7.** The precursor compound of claim 6, wherein $R^3$, $R^4$ and $R^5$ are each hydrogen; each of $\ell$ and m is 1; and $R^{14}$ is methyl or ethyl.

**8.** The precursor compound of claim 1 wherein L is a heterocyclic amine of formula (5) or formula (4):

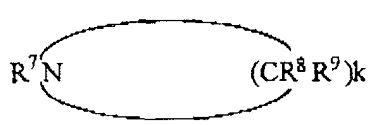

(3)

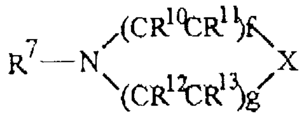

(4)

wherein $R^7$ is hydrogen or alkyl group containing 1 to 4 carbon atoms; $R^8$ and $R^9$ are the same or different and are hydrogen or an alkyl group containing 1 to 2 carbon atoms;
$R^{10}$ to $R^{13}$ are the same or different and are hydrogen or an alkyl group containing 1 to 2 carbon atoms, X is oxygen, or nitrogen having hydrogen or alkyl group containing 1 to 4 carbon atoms; f and g are integers of 1 to 3; and k is an integer of 2 to 8.

**9.** The precursor compound of claim 9, wherein $R^7$ is hydrogen or alkyl containing 1 to 4 carbon atoms; $R^8$ is hydrogen; $R^9$ is hydrogen or alkyl group containing 1 to 2 carbon atoms; and k is 2.

**10.** The precursor compound of claim 8, wherein the heterocyclic amine has the formula (10):

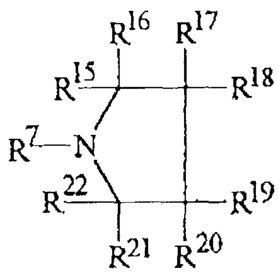

(10)

wherein $R^7$ is hydrogen or alkyl group containing 1 to 4 carbon atoms and $R^{15}$ to $R^{22}$ are the same or different and are hydrogen or an alkyl group containing 1 to 2 carbon atoms.

**11.** The precursor compound of claim 8, wherein the heterocyclic amine has the formula (11):

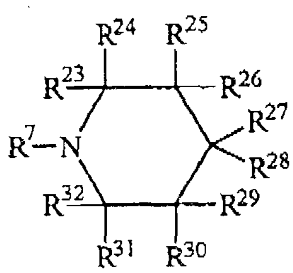

(11)

wherein $R^7$ is hydrogen or alkyl group containing 1 to 4 carbon atoms and $R^{23}$ to $R^{32}$ are the same to or different and are hydrogen or alkyl group containing 1 to 2 carbon atoms.

**12.** The precursor compound of claim 8, wherein the heterocyelic amine has the formula (12),

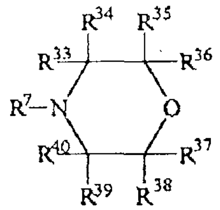

(12)

wherein $R^7$ is hydrogen or an alkyl group containing 1 to 4 carbon atoms; and $R^{33}$ to $R^{40}$ are the same to or different and are hydrogen or an alkyl group containing 1 to 2 carbon atoms.

**13.** The precursor compound of claim 8, wherein the heterocyclic amine has the formula (13),

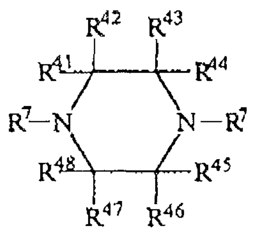

(13)

wherein $R^7$ is hydrogen or an alkyl group containing 1 to 4 carbon atoms; and $R^{41}$ to $R^{48}$ are the same or different and are hydrogen or an alkyl group containing 1 to 2 carbon atoms.

**14.** A process for preparing a precursor compound of claim 1 comprising the steps of:

a) adding a beta-diketone to a metal alkoxide to form a reaction mixture;
b) adding a perfluoroalkylalcohol or an alkoxyalkylalcohol to the reaction mixture;
c) stirring the reaction mixture; and
d) reacting the reaction mixture with a Lewis base.

**15.** A solution comprising the precursor compound of claim 1, and a heterocyclic amine of formula (3) or formula (4),

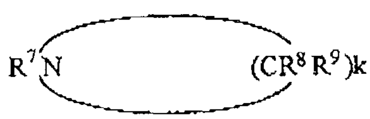

(3)

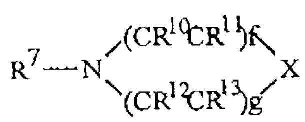

(4)

wherein $R^7$ is hydrogen or an alkyl group containing 1 to 4 carbon atoms; $R^8$ and $R^9$ are the same or different and are hydrogen or an alkyl group containing 1 to 2 carbon atoms; $R^{10}$ to $R^{13}$ are the same or different and are represent hydrogen or an alkyl group containing 1 to 2 carbon atoms; X is oxygen, or nitrogen having hydrogen or alkyl group containing 1 to 4 carbon atoms; f and g are integers of 1 to 3; and k is an integer of 2 to 8; wherein the heterocyclic amine is present in an amount sufficient to dissolve the precursor compound.

**16.** A method for depositing a metal oxide film on a substrate comprising the step of heating the substrate to a temperature of 300 to 600°C in oxygen during contact with the precursor compound of claim 1.

**17.** The method of claim 16 further comprising the step of vaporizing the precursor compound using an excitation source selected from the group consisting of heat, plasma or a bias applied to the substrate.

Figure 1

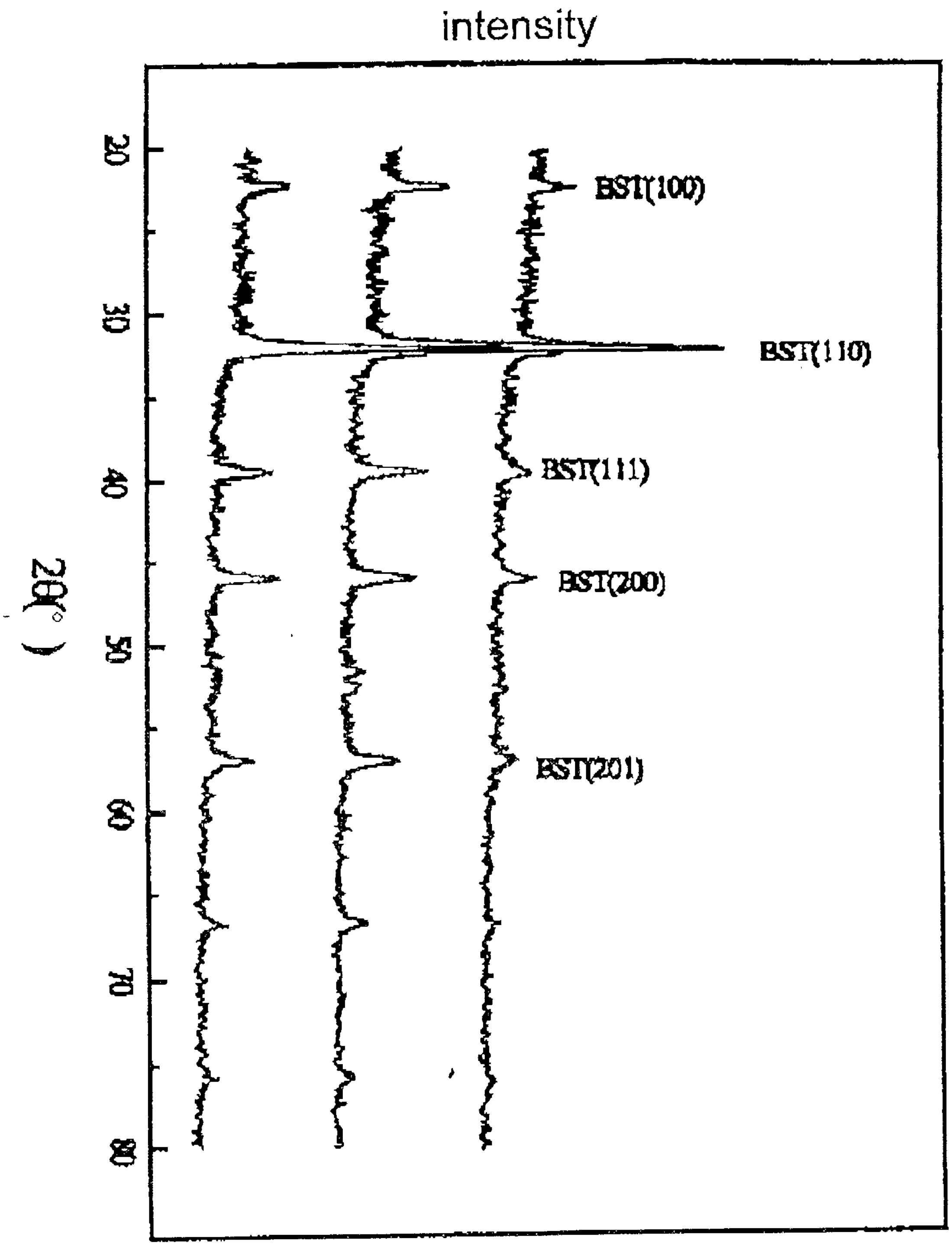
intensity
2θ(°)
20
30
40
50
60
70
80
BST(100)
BST(110)
BST(111)
BST(200)
BST(201)

European Patent Office

# EUROPEAN SEARCH REPORT

Application Number
EP 01 30 9542

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | WO 88 07759 A (PLESSEY OVERSEAS) 6 October 1988 (1988-10-06) * page 7 * --- | 1,8-13, 16,17 | C07F7/00 C07F19/00 C23C14/58 C23C14/24 |
| A | PATENT ABSTRACTS OF JAPAN vol. 012, no. 326 (C-525), 5 September 1988 (1988-09-05) & JP 63 089667 A (NEC CORP), 20 April 1988 (1988-04-20) * abstract * ----- | 1,15,16 | |
| | | | TECHNICAL FIELDS SEARCHED (Int.Cl.7) |
| | | | C07F C23C |

The present search report has been drawn up for all claims

| Place of search | Date of completion of the search | Examiner |
|---|---|---|
| THE HAGUE | 10 April 2002 | Bader, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 01 30 9542

This annex lists the patent family members relating to the patent documents cited in the above-mentioned European search report.
The members are as contained in the European Patent Office EDP file on
The European Patent Office is in no way liable for these particulars which are merely given for the purpose of information.

10-04-2002

| Patent document cited in search report | Publication date | Patent family member(s) | Publication date |
|---|---|---|---|
| WO 8807759 A | 06-10-1988 | GB 2202865 A | 05-10-1988 |
| | | EP 0307444 A1 | 22-03-1989 |
| | | WO 8807759 A1 | 06-10-1988 |
| | | JP 1503151 T | 26-10-1989 |
| | | US 5045348 A | 03-09-1991 |
| | | ZA 8802169 A | 26-04-1989 |
| JP 63089667 A | 20-04-1988 | JP 2595943 B2 | 02-04-1997 |

EPO FORM P0459

For more details about this annex : see Official Journal of the European Patent Office, No. 12/82